Europäisches Patentamt

European Patent Office

Office européen des brevets

(11) Veröffentlichungsnummer: **0 006 492**
**B1**

(12) **EUROPÄISCHE PATENTSCHRIFT**

(45) Veröffentlichungstag der Patentschrift:
25.11.81

(21) Anmeldenummer: 79101775.9

(22) Anmeldetag: 05.06.79

(51) Int. Cl.³: **G 08 C 19/48**, G 01 D 5/243,
G 01 R 25/00

(54) Verfahren zur digitalen Interpolation einer Periode eines dreiphasigen Analogsignals.

(30) Priorität: 26.06.78 CH 6929/78

(43) Veröffentlichungstag der Anmeldung:
09.01.80 Patentblatt 80/1

(45) Bekanntmachung des Hinweises auf die Patenterteilung:
25.11.81 Patentblatt 81/47

(84) Benannte Vertragsstaaten:
AT BE CH DE FR GB IT NL SE

(56) Entgegenhaltungen:
US-A- 3 533 097

(73) Patentinhaber: **CONTRAVES AG,**
**Schaffhauserstrasse 580, CH-8052 Zürich (CH)**

(72) Erfinder: **Guenin, Albert, Dipl.-El.-Ing.ETH,**
**Hauptstrasse 140, CH-4411 Arisdorf (CH)**

(74) Vertreter: **Köver, François, Dr. et al, Patentanwälte**
**H.Mitscherlich K. Gunschmann, Dr. W. Körber,**
**J.Schmidt-Evers Steinsdorfstrasse 10,**
**D-8000 München 22 (DE)**

0 006 492

## Verfahren zur digitalen Interpolation einer Periode eines dreiphasigen Analogsignals

Die Erfindung betrifft ein Verfahren zur digitalen Interpolation einer Periode eines dreiphasigen Analogsignals, dessen Komponenten (Phasen) eine periodische Funktion einer Meßgröße — insbesondere der Position bei einer Längen- oder Winkelmessung — sind, gemäß dem Oberbegriff des Anspruchs 1.

Es ist bekannt, ein Analogsignal der eingangs erwähnten Art zu erzeugen, zu digitalisieren und zwecks Lieferung eines Meßwertes auszuwerten (vgl. dazu beispielsweise das Patentdokument CH-A-499 091). Es ist auch bekannt, die Periode des Analogsignals zu interpolieren, um die Auflösung der digitalen Auswertung zu verbessern (vgl. dazu beispielsweise die Patentdokumente CH-A-407 569, DE-A-2 642 925 und US-A-3 310 798).

Für hochpräzise Meßgeräte wie z. B. Flugbahnvermessungs-Theodoliten ist eine geeignete Auflösung mit dem beispielsweise aus dem Patentdokument US-A-3 533 097 entnehmbaren Interpolationsverfahren erreichbar. In diesem Patentdokument wird von einem dreiphasigen Analogsignal ausgegangen, dessen Phasenargument eine lineare Funktion einer Meßgröße ist, so daß die drei Komponenten (Phasen) des Analogsignals je eine periodische Funktion der Meßgröße sind. Die Werte der Komponenten werden mit Null sowie zu zweien untereinander verglichen; jeder möglichen Kombination der Vergleichsergebnisse wird je eine im Bereich der Phasenargumente des Analogsignals definierte Zone zugeordnet. Daraus ergibt sich eine Grob-Interpolation einer Periode des Analogsignals in 12 Zonen des Phasenarguments. In jeder Zone wird die Komponente mit dem jeweils kleinsten Absolutwert ausgewählt: die Variation dieser Komponente mit dem Phasenargument ist diejenige einer Sinusfunktion, deren Argument zwischen 0 und $\frac{\pi}{12}$ variiert, folglich weicht die Variation der ausgewählten Komponente mit der Meßgröße von der Linearität ab. Bei der Analog/Digital-Wandlung der ausgewählten Komponente wird gleichzeitig die erwähnte Abweichung kompensiert, so daß ein Digitalwert erhalten wird, der (abgesehen von der Quantisierung) eine lineare Funktion der Meßgröße ist. Auf diese Weise wird eine Fein-Interpolation der Zone in Schritt erreicht, wobei die Anzahl Schritte in der Zone gleich dem höchstmöglichen Digitalwert ist. Das gewünschte Resultat der Interpolation ergibt sich aus der Kombination der erreichten Anzahl Zonen und der erreichten Anzahl Schritte, wobei je nach der erreichten Anzahl Zonen die Anzahl Schritte positiv oder negativ gewertet wird, um den Symmetrieeigenschaften der Variation der Komponenten mit dem Phasenargument Rechnung zu tragen.

Ein erster Nachteil dieses Interpolationsverfahrens ist, daß eine besondere Schaltung zur Linearisierung der Variation des Digitalwertes mit der Meßgröße benötigt wird. Ein weiterer Nachteil ist, daß die ausgewählte Komponente unbedingt eine Sinusfunktion der Meßgröße sein muß, da sonst die Fein-Interpolation fehlerhaft wird. Es wird nämlich vorausgesetzt, daß jedem Digitalwert eindeutig je ein Schritt des Phasenarguments zugeordnet werden kann. Im Patentdokument US-A-3 533 097 werden Maßnahmen beschrieben, um diese Zuordnung und folglich das Resultat der Interpolation von Schwankungen der Amplitude der Sinusfunktion zu befreien; zur Durchführung dieser Maßnahmen ist es jedoch erforderlich, das dreiphasige Analogsignal als dreiphasige Wechselspannung zu erzeugen und zusätzlich eine als Amplituden- und Phasenreferenz dienende Wechselspannung vorzusehen. Daher ist die Lehre aus dem Patentdokument US-A-3 533 097 nicht ohne weiteres auf die Interpolation andersartiger Analogsignale anwendbar, insbesondere nicht auf die Interpolation eines Signals, welches von der im Patentdokument CH-A-466 593 beschriebenen Einrichtung zum Ablesen von Moiré-Streifenbildern in einem hochpräzisen Winkelmeßsystem eines Flugbahnvermessungs-Theodoliten geliefert wird. Das Signal aus der erwähnten Einrichtung ist nämlich keine Wechselspannung, es ist nur über die Meßgröße zeitabhängig und bleibt beim Stillstand des Theodoliten im Prinzip konstant; zudem wird dieses Signal von Fotozellen erzeugt, so daß einerseits der Mittelwert des Analogsignals um einen Gleichspannungsanteil verschoben werden kann und andererseits bei jeder Komponente deutliche Abweichungen vom idealen sinusförmigen Verlauf in Abhängigkeit der Meßgröße auftreten können.

Aufgabe der Erfindung ist es, ein Verfahren der eingangs erwähnten Art zu schaffen, das auch auf solche Analogsignale anwendbar ist, deren Verlauf von einer Sinusfunktion der Meßgröße abweichen kann und deren Amplitude und Mittelwert zeitliche Schwankungen aufweisen können.

Zur Lösung dieser Aufgabe ist ein Verfahren der eingangs erwähnten Art gekennzeichnet durch die im Anspruch 1 aufgeführten Verfahrensschritte. Eine vorteilhafte Weiterbildung des Verfahrens ergibt sich aus dem Unteranspruch.

Im folgenden wird die Erfindung unter Bezugnahme auf die Zeichnungen näher beschrieben, wobei in allen Figuren die einander entsprechenden Elemente mit denselben Bezugszeichen versehen sind. Es zeigt

Fig. 1 ein Blockschema einer Schaltung zur Durchführung des Verfahrens,

Fig. 2 ein Diagramm zur Veranschaulichung der Unterteilung der Periode eines dreiphasigen Analogsignals in Zonen,

2

Fig. 3 ein Diagramm zur Veranschaulichung der Werte X, Y, Z in der Zone 0 der Fig. 2,

Fig. 4 eine Ausbildung der Adressierschaltung 9 und des Selektors 11 der Fig. 1,

Fig. 5 ein Diagramm zur Veranschaulichung der Werte H und K in der Zone 0 der Fig. 2,

Fig. 6 eine aufgrund von Fig. 5 erstellte Tabelle zum Bezeichnen eines einem Wertepaar H, K entsprechenden Phasenabschnittes einer Zone,

Fig. 7 eine andere Ausbildung des Selektors 11 der Fig. 1,

Fig. 8 ein Diagramm zur Veranschaulichung der Unterteilung der Periode eines zwei- oder vierphasigen Analogsignals in Zonen.

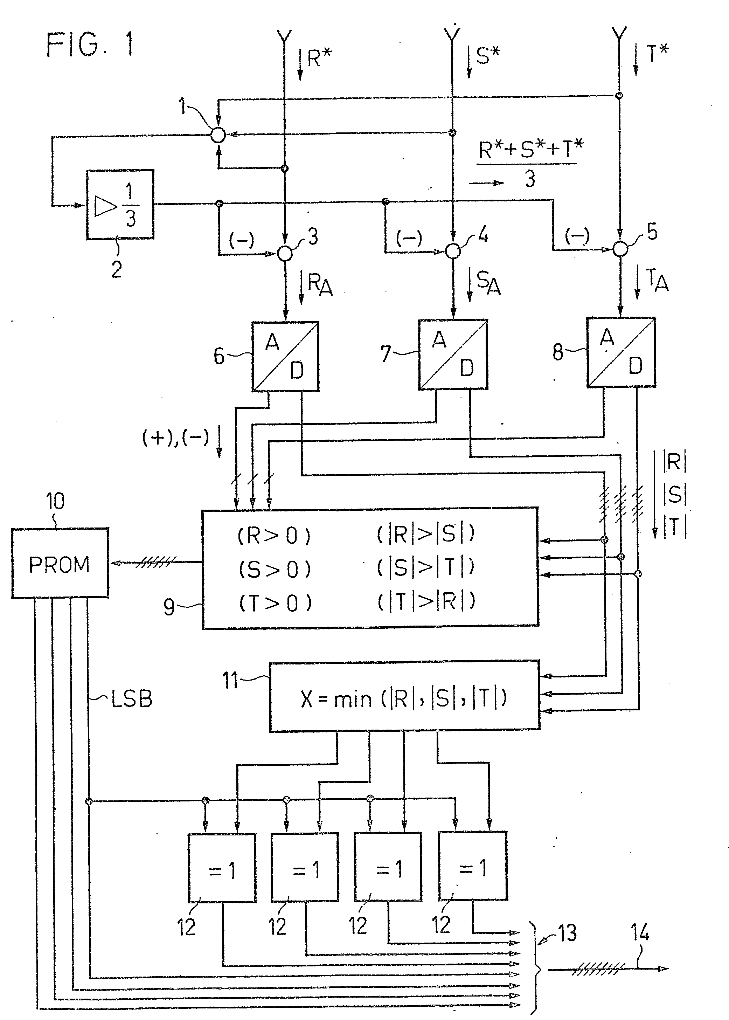

Fig. 1 zeigt im Blockschema eine Schaltung zur digitalen Interpolation eines dreiphasigen Analogsignals $R^*$, $S^*$, $T^*$, das beispielsweise in einer Winkelmeßeinrichtung nach dem Patentdokument CH-A-466 593 oder durch einen dreiphasigen Synchron-Generator erzeugt wird, wobei die Komponenten (Phasen $R^*$, $S^*$, $T^*$ in Abhängigkeit eines Drehwinkels etwa sinusförmig variieren und zueinander um $\pm \dfrac{2\pi}{3}$ phasenverschoben sind. Aus den Komponenten $R^*$, $S^*$, $T^*$ werden Digitalwerte erzeugt, die um den Wert Null symmetrisch liegen. Zu diesem Zweck wird von jeder Komponente $R^*$, $S^*$, $T^*$ der Wert $\dfrac{1}{3} \cdot (R^* + S^* + T^*)$ subtrahiert: es läßt sich zeigen, daß bei einem dreiphasigen Analogsignal, das aus den korrigierten Komponenten $R_A$, $S_A$, $T_A$ mit

$$R_A = R^* - \frac{R^* + S^* + T^*}{3}$$

$$S_A = S^* - \frac{R^* + S^* + T^*}{3}$$

$$T_A = T^* - \frac{R^* + S^* + T^*}{3}$$

besteht, jeweils zwei der korrigierten Komponenten gleicher Amplitude und entgegengesetzten Vorzeichens sind, wenn die dritte korrigierte Komponente gleich Null wird. Diese Eigenschaft ist unabhängig von möglichen Fehlern des gesamten dreiphasigen Analogsignals $R^*$, $S^*$, $T^*$ wie z. B. eine Verschiebung des Nullpegels oder eine gemeinsame Modulation der Amplituden oder der Phasen der drei Komponenten. Die Schaltung zum Bilden der korrigierten Komponenten $R_A$, $S_A$, $T_A$ aus den Komponenten $R^*$, $S^*$, $T^*$ besteht im wesentlichen aus einem Addierwerk 1, einem Verstärker 2 mit Verstärkungsfaktor $\dfrac{1}{3}$ und drei Subtrahierwerken 3, 4, 5, wobei es bekannt ist, diese Funktionen durch Rechenverstärker in geeigneter Schaltung zu verwirklichen. Die analogen Komponenten $R_A$, $S_A$, $T_A$ werden in je einem Analog/Digital-Wandler 6, 7, 8 in digitale Werte R, S, T gewandelt, wobei am Ausgang jedes Wandlers je ein 6-bit-Digitalwert (5-bit-Absolutwert und 1 bit für das Vorzeichen) ansteht.

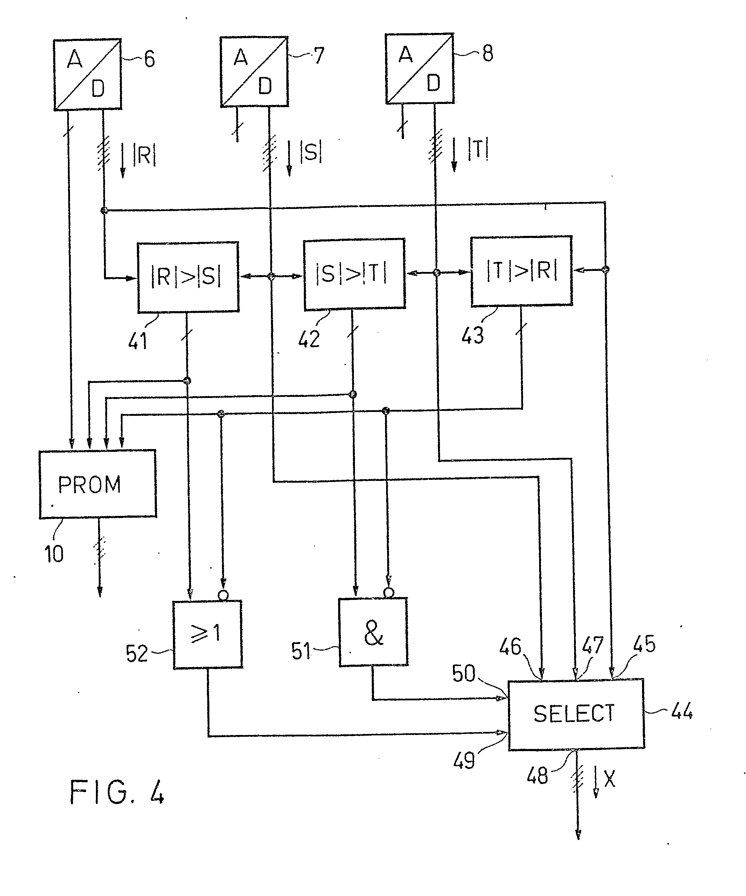

Die Werte R, S, T werden dem Eingang einer Adressierungsschaltung 9 zugeführt. In dieser Adressierungsschaltung 9, deren Ausbildung weiter unten im Zusammenhang mit Fig. 4 beschrieben wird, wird das gesamte Feld der möglichen Werte der digitalen Komponenten R, S, T in eine Anzahl Zonen unterteilt, denen je eine Kombination von Entscheidungen zu den sechs folgenden Ungleichungen eindeutig zugeordnet ist:

(a) $R > 0$      (d) $|R| > |S|$

(b) $S > 0$      (e) $|S| > |T|$

(c) $T > 0$      (f) $|T| > |R|$

Zur Behebung der Unsicherheitsfälle wird bestimmt, daß jedem Grenzfall wie $R = 0$ oder $|R| = |S|$ die Entscheidung »Nichterfüllung« zugeordnet wird. Die jeder der sechs Ungleichungen zugeordnete Entscheidung wird beispielsweise gemäß der Regel »Erfüllung = 1, Nichterfüllung = 0« logisch ausgedrückt und zur Adressierung eines Zuordnungsspeichers 10, vorzugsweise eines PROM, verwendet. Zu diesem Zweck führt eine 6-bit-Leitung vom Ausgang der Adressierschaltung 9 zum Adressiereingang des Zuordnungsspeichers 10.

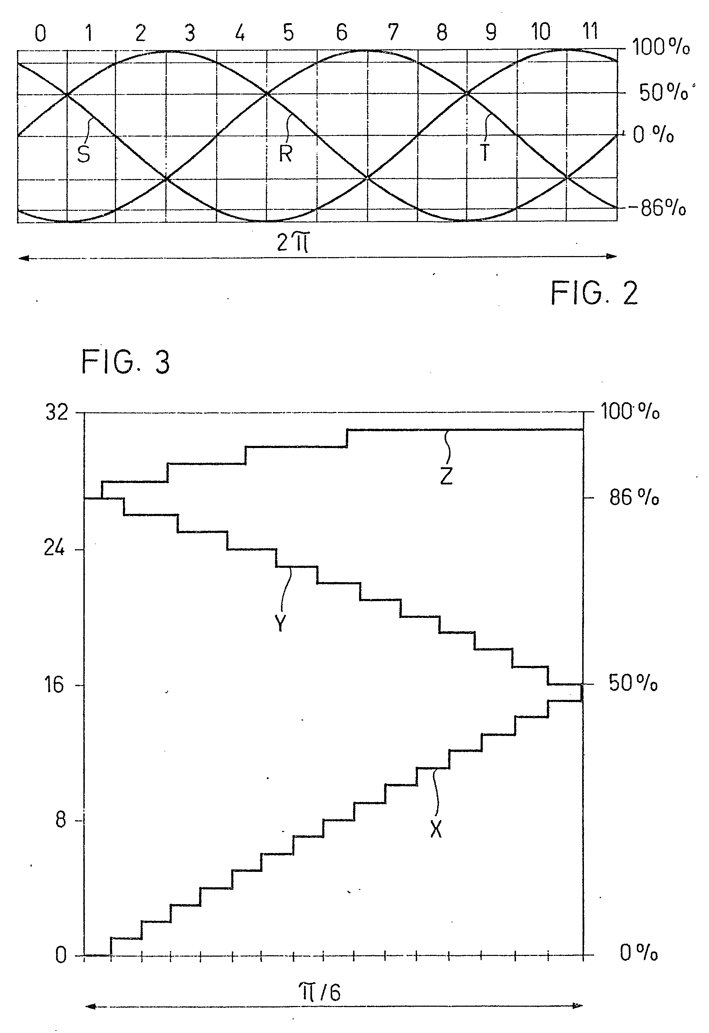

Fig. 2 und die nachstehende Tabelle I veranschaulichen die mit den Werten R, S, T möglichen Kombinationen von Entscheidungen zu den sechs Ungleichungen (a) ... (f). In Fig. 2 wird eine volle Periode der Kombination von Werten R, S, T dargestellt. Entlang der Abszisse wird die Phase

3

eingetragen, die den momentanen Werten R, S, T entspricht, während diese momentanen Werte entlang der Ordinate eingetragen werden, wobei die Amplitude gleich 100% gesetzt wird. Obwohl die Werte R, S, T digital gegeben und daher quantisiert sind, ist dies in Fig. 2 nicht erkennbar, weil die Auflösung entlang der Ordinate beim Maßstab der Zeichnung dazu nicht ausreicht. Es ist aus Fig. 2 ersichtlich, daß entlang der Abszisse, also im Phasenbereich, die Periode in 12 Zonen gleicher Breite unterteilbar ist, wobei jeweils ein Zonenwechsel dort stattfindet, wo mindestens einer der Werte R, S, T einen der Ordinatenwerte 0%, ±50%, ±86% durchschreitet. Beim Zonenwechsel ändert sich also mindestens eine der Entscheidungen »1« oder »0« zu den sechs Ungleichungen (a) ... (f), was in der Tabelle I veranschaulicht wird:

Tabelle I

| Zone: | 0 | 1 | 2 | 3 | 4 | 5 | 6 | 7 | 8 | 9 | 10 | 11 |
|---|---|---|---|---|---|---|---|---|---|---|---|---|
| (a): | 1 | 1 | 1 | 1 | 1 | 1 | 0 | 0 | 0 | 0 | 0 | 0 |
| (b): | 1 | 1 | 0 | 0 | 0 | 0 | 0 | 0 | 1 | 1 | 1 | 1 |
| (c): | 0 | 0 | 0 | 0 | 1 | 1 | 1 | 1 | 1 | 1 | 0 | 0 |
| (d): | 0 | 1 | 1 | 1 | 0 | 0 | 0 | 1 | 1 | 1 | 0 | 0 |
| (e): | 0 | 0 | 0 | 1 | 1 | 1 | 0 | 0 | 0 | 1 | 1 | 1 |
| (f): | 1 | 1 | 0 | 0 | 0 | 1 | 1 | 1 | 0 | 0 | 0 | 1 |

Die Bezeichnung der Zonen erfolgt durch eine Zahl zwischen 0 und 11, deren Ausdruck im binären Zahlensystem 4 bit benötigt. Daher ist der Zuordnungsspeicher 10 mit einem 4-bit-Ausgang versehen. Er ist derart programmiert, daß, wenn er entsprechend der Entscheidungen zu den sechs Ungleichungen (a) ... (f) adressiert wird, an seinem Ausgang die Bezeichnung der gemäß Tabelle I zugeordneten Zone ansteht. Auf diese Weise entsteht eine Interpolation der Periode des dreiphasigen Analogsignals $R^*$, $S^*$, $T^*$ in 12 Zonen.

Der Absolutwert der Komponenten R, S, T wird als 5-bit-Binärzahl von den Analog/Digital-Wandlern 6, 7, 8 abgegeben; durch eine geeignete Verstärkung z. B. der Komponenten $R_A$, $S_A$, $T_A$ kann die Amplitude der Komponenten so eingestellt werden, daß die 5-bit Auflösung (32-Schritte) voll ausgenutzt wird. Andererseits läßt ein Vergleich der verschiedenen Zonen der Fig. 2 untereinander erkennen, daß in jeder Zone dieselben Absolutwerte je einer der Komponenten R, S, T vorkommen, während der Verlauf dieser Absolutwerte im Phasenbereich — d. h. als Funktion der Abszisse — in je zwei benachbarten Zonen um die dazwischenliegende Zonengrenze spiegelsymmetrisch ist (Zone 0 und Zone 11 gelten als benachbart).

Es werden nun drei Werte X, Y, Z so definiert, daß X jeweils der kleinste, Y der mittlere und Z der größte der drei Absolutwerte $|R|$, $|S|$, $|T|$ ist. In Fig. 3 sind die Werte X, Y, Z innerhalb der Zone 0 der Fig. 2 dargestellt, wobei auf der Abszisse der Phasenverlauf in der Zone und auf der Ordinate die entsprechenden momentanen Werte eingetragen werden. Der Maßstab der Zeichnung läßt hier die Quantisierung erkennen; wie ersichtlich endet der 32. Schritt bei der Amplitude 100%. Wie sich aus dem vorangehenden ergibt, ist bei allen 12 Zonen der Verlauf der Werte X, Y, Z durch dieselbe Fig. 3 darstellbar, sofern auf der Abszisse der geeignete Phasenabschnitt mit der geeigneten Richtung dargestellt wird: die Breite des dargestellten Phasenabschnittes ist bei allen Zonen gleich $\frac{\pi}{6}$, was dem

Abstand zwischen zwei Zonengrenzen im Phasenbereich entspricht, die Phase wächst aber entlang der Abszisse von links nach rechts bei den Zonen 0, 2, 4, 6, 8, 10 und von rechts nach links bei den Zonen 1, 3, 5, 7, 9, 11. Da eine Amplitude von 100% in 32 Schritten quantisiert wird, ist ein Schritt genau 3,125% wert. Daher umfaßt der Änderungsbereich von X die Schritte 0 bis 15, derjenige von Y die Schritte 16 bis 27 und derjenige von Z die Schritte 27 bis 31. Fig. 3 läßt erkennen, daß die Änderung von X im Durchschnitt ziemlich linear verläuft: daher kann die Quantisierung von X in 16 Schritte zur

Quantisierung des $\frac{\pi}{6}$ — Phasenschnittes jeder Zone herangezogen werden, indem zwischen jedem Schritt von X und je einem entsprechenden Phasenabschnitt eine ein-eindeutige Zuordnung erstellbar ist. Auf diese Weise entsteht eine Interpolation der Zonen in je 16 Schritte.

Die Bildung des Wertes X aus den Absolutwerten $|R|$, $|S|$, $|T|$ erfolgt (vgl. Fig. 1) in einem Selektor 11, der weiter unten im Zusammenhang mit Fig. 4 beschrieben wird. Die Absolutwerte $|R|$, $|S|$, $|T|$ werden

4

über je eine 5-bit-Leitung vom Ausgang je eines Analog/Digital-Wandlers 6, 7, 8 zum Eingang des Selektors 11 geführt, d. h., vom 6-bit-Ausgang der jeweiligen Analog/Digital-Wandler wird hier die das Vorzeichen führende Leitung nicht verwendet. Am Ausgang des Selektors 11 erscheint auf einer 4-bit-Leitung der Wert X, der gleich dem kleineren der Werte $|R|$, $|S|$, $|T|$ ist (eine 4-bit-Leitung genügt, da die Variationsspanne von X nur 16 Schritte beträgt).

Eine volle Periode des Analogsignals $R^*$, $S^*$, $T^*$ wird also in 12 Zonen zu je 16 Schritten, d. h. in total 192 Schritte unterteilt. Im Binärsystem wird jeder dieser 192 Schritte durch eine 8-bit-Zahl zwischen 00000000 und 10111111 bezeichnet. Die vier höchstwertigen bits dieser Zahl entsprechen der Zonenbezeichnung, d. h. dem Ausgang des Zuordnungsspeichers 10. Die vier niedrigstwertigen bits dieser Zahl entsprechen der Schrittbezeichnung, d. h. dem Ausgang des Selektors 11, hier aber ist es nötig, bei den Zonen 1, 3, 5, 7, 9, 11 die Umkehr der Abszissenrichtung in Fig. 3 zu berücksichtigen. Während also bei den Zonen 0, 2, 4, 6, 8, 10 die vier niedrigstwertigen bits der Binärzahl dem Ausgang des Selektors 11 direkt entnehmbar sind, sind diese vier niedrigstwertigen bits bei den Zonen 1, 3, 5, 7, 9, 11 gleich dem Komplement der dem Ausgang des Selektors 11 entnehmbaren Binärzahl (es läßt sich zeigen, daß auf diese Weise die Schritte in Fig. 3 von rechts nach links gezählt werden). Zu diesem Zweck sind in Fig. 1 vier Antivalenz-Glieder (Exklusiv-ODER-Tore) 12 vorgesehen: je einem dieser Antivalenz-Glieder 12 werden eingangsseitig je eines der vier bits vom Ausgang des Selektors 11 sowie das niedrigstwertige bit LSB vom Ausgang des Zuordnungsspeichers 10 zugeführt. Wenn also die Zonenbezeichnung gerade ist, erscheinen die vier bits des Ausganges des Selektors 11 unverändert auch an den jeweiligen Ausgängen der Antivalenz-Glieder 12; wenn hingegen die Zonenbezeichnung ungerade ist, bewirkt die Antivalenzfunktion die Komplementierung der jeweiligen vier bits des Ausganges des Selektors 11, am Ausgang des jeweiligen Antivalenz-Gliedes erscheint das gewünschte Komplement. Anschließend erfolgt bei 13 die Vereinigung der Ausgänge des Zuordnungsspeichers 10 und der Antivalenz-Glieder 12 zur Bildung der im vorangehenden definierten 8-bit-Binärzahl, welche auf der 8-bit-Leitung 14 ansteht und das Ergebnis der Interpolation des dreiphasigen Analogsignals $R^*$, $S^*$, $T^*$ in 192 Schritte pro Periode in digitaler Form darstellt. Fig. 4 zeigt eine Ausbildung der Adressierschaltung 9 und des Selektors 11 der Fig. 1, wobei einige Elemente der Fig. 1 mit gleichen Bezugszeichen in Fig. 4 dargestellt werden. Die Adressierschaltung 9 der Fig. 1 besteht in Fig. 4 aus den Elementen, die die Verbindung zwischen den Analog/Digital-Wandlern 6, 7, 8 und dem Zuordnungsspeicher 10 erstellen. Gegenüber dem allgemeineren Funktionsschema der Fig. 1 wurde die Schaltung in Fig. 4 vereinfacht: aus der Tabelle I ist zu entnehmen, daß zur vollständigen Bezeichnung einer Zone eine 4-bit-Information genügt, nämlich je ein bit für die Entscheidung zu den Absolutwert-Ungleichungen (d), (e), (f) und noch ein bit für nur eine der Entscheidungen zu den Vorzeichen-Ungleichungen (a), (b), (c). Die Entscheidungen (d), (e), (f) werden in je einem digitalen Vergleicher 41, 42, 43 getroffen: je einem Eingang eines dieser Vergleicher wird einer der Werte $|R|$, $|S|$, $|T|$ vom entsprechenden Ausgang eines der Analog/Digital-Wandler 6, 7, 8 zugeleitet. Am Ausgang des Vergleichers 41 erscheint beispielsweise der logische Wert »1«, wenn $|R| > |S|$ gilt, und »0«, wenn $|R| \le |S|$ gilt. Sinngemäß gilt dasselbe für die Vergleicher 42 und 43, d. h., es erscheint jeweils »1«, wenn $|S| > |T|$ bzw. $|T| > |R|$ gilt, und »0« in den anderen Fällen. Die Ausgänge der Vergleicher 41, 42, 43 sind mit je einem zugehörigen Adressiereingang des Zuordnungsspeichers 10 verbunden; zur Vervollständigung der Adressierung ist der Vorzeichen-Ausgang des Analog/Digital-Wandlers 6 mit einem zugeordneten Adressiereingang des Zuordnungsspeichers 10 verbunden, so daß beispielsweise der logische Wert »1« diesem Eingang zugeleitet wird, wenn $R > 0$ gilt. Der Zuordnungsspeicher 10 ist beispielsweise ein PROM, dessen Funktion gemäß der nachstehenden Tabelle II programmiert wird; es ist ersichtlich, daß der Informationsinhalt der Tabellen I und II derselbe ist, d. h., Tabelle I ist redundant. Am Ausgang des Zuordnungsspeichers 10 erscheint auf einer 4-bit-Leitung die Angabe der Zonenbezeichnung (0 bis 11) im Binärsystem. Es ist noch zu erwähnen, daß die Entscheidungen (a) bis (f) auch aufgrund einer Analyse der analogen Komponenten $R_A$, $S_A$, $T_A$ getroffen werden können, es werden dann analoge Vergleicher verwendet; an diesem Teil des Verfahrens ändert sich dabei nichts Wesentliches.

Tabelle II

| Zone: | 0 | 1 | 2 | 3 | 4 | 5 | 6 | 7 | 8 | 9 | 10 | 11 |
|---|---|---|---|---|---|---|---|---|---|---|---|---|
| Signal | | | | | | | | | | | | |
| aus 6: | 1 | 1 | 1 | 1 | 1 | 1 | 0 | 0 | 0 | 0 | 0 | 0 |
| aus 41: | 0 | 1 | 1 | 1 | 0 | 0 | 0 | 1 | 1 | 1 | 0 | 0 |
| aus 42: | 0 | 0 | 0 | 1 | 1 | 1 | 0 | 0 | 0 | 1 | 1 | 1 |
| aus 43: | 1 | 1 | 0 | 0 | 0 | 1 | 1 | 1 | 0 | 0 | 0 | 1 |

0 006 492

Der Selektor 11 der Fig. 1 besteht in Fig. 4 aus den Elementen, die die Verbindung zwischen den Analog/Digital-Wandlern 6, 7, 8 und den Antivalenz-Gliedern 12 erstellen. Ein Selektionselement 44 erhält auf je einem Werteingang 45, 46, 47 je einen der Werte |R|, |S|, |T| vom Ausgang des entsprechenden Analog/Digital-Wandlers 6, 7, 8. Das Selektionselement 44 ist mit einen 4-bit-Ausgang 48 versehen, von wo je ein bit je einem der Antivalenz-Glieder 12 zugeführt wird. Schließlich ist das Selektionselement 44 mit zwei Steuereingängen 49 und 50 versehen. Je nach dem an den Steuereingängen 49 und 50 anstehenden binären Kode erscheint am Ausgang 48 des Selektionselementes 44 einer der an seinen Werteingängen 45, 46, 47 anstehenden Werte |R|, |S|, |T|; die Zuordnung zwischen dem Kode und dem zum Ausgang durchgeschalteten Werteingang erfolgt gemäß einer vorbestimmten Selektionstabelle, beispielsweise der nachstehenden Tabelle III; entsprechende Selektionselemente sind käuflich.

Tabelle III

| An den Steuer-eingängen 49 und 50 anstehender Kode | Der Ausgang 48 wird dann verbunden mit |
|---|---|
| 0  0 | Eingang 45 |
| 0  1⎫<br>1  0⎭ | Eingang 46 |
| 1  1 | Eingang 47 |

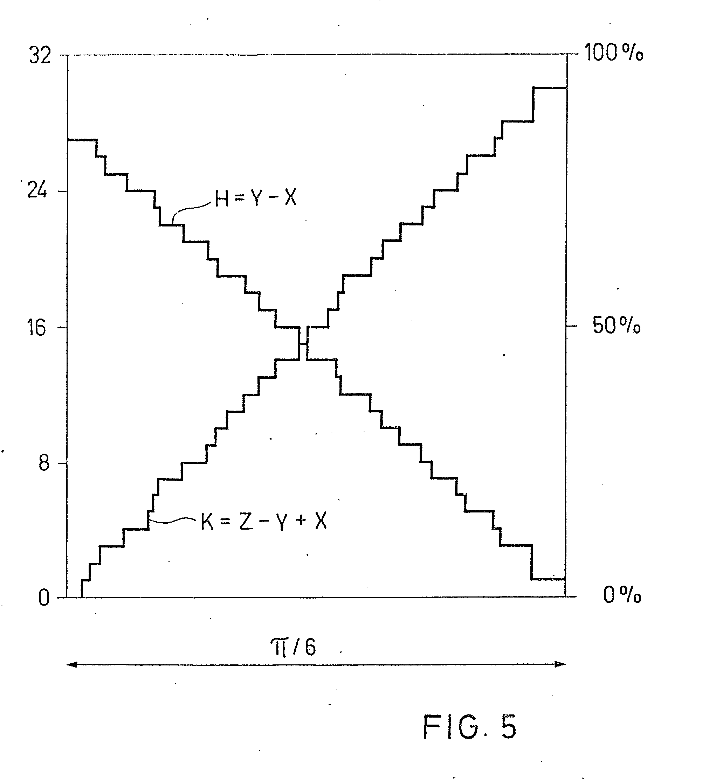

Aus Fig. 2 ist ersichtlich, daß der kleinste der drei Werte |R|, |S|, |T| in den Zonen 0, 5, 6, 11 der Wert |R|, in den Zonen 1, 2, 7, 8 der Wert |S| und in den Zonen 3, 4, 9, 10 der Wert |T| ist. Die entsprechenden Entscheidungen zu den Absolutwert-Ungleichungen (d), (e), (f) sind aus der Tabelle II ersichtlich. Es läßt sich zeigen, daß die Kombination von Entscheidungen (d), (e), (f), die zum richtigen Kode auf den Steuereingängen des Selektionselementes 44 führt, darin besteht, daß je einem Steuereingang je eine der Booleschen Funktionen $(e * \bar{f})$ und $(d + \bar{f})$ zugeführt wird. Dies wird beispielsweise mit der im nachstehenden beschriebenen und in Fig. 4 dargestellten Schaltung erreicht, wobei andere Ausbildungen z. B. mit einem Zuordnungsspeicher ebenso möglich sind. Ein UND-Glied 51 erhält auf einem nichtinvertierenden Eingang den Wert (e) vom Ausgang des Vergleichers 42 und auf einem invertierenden Eingang den Wert (f) vom Ausgang des Vergleichers 43. Der Wert $(e * \bar{f})$ erscheint am Ausgang des UND-Gliedes 51 und wird dem Steuereingang 50 des Selektionselementes 44 zugeführt. Ein ODER-Glied 52 erhält auf einem nichtinvertierenden Eingang den Wert (d) vom Ausgang des Vergleichers 41 und auf einem invertierenden Eingang des Wertes (f) vom Ausgang des Vergleichers 43. Der Wert $(d + \bar{f})$ erscheint am Ausgang des ODER-Gliedes 52 und wird dem Steuereingang 50 des Selektionselementes 44 zugeführt. Da der Wert von X höchstens 16 Schritte beträgt, genügt eine 4-bit-Leitung am Ausgang 48 des Selektionselementes 44. Aus demselben Grund würde je eine 4-bit-Leitung zur Zuleitung der Werte |R|, |S|, |T| zu den Werteingängen des Selektionselementes 44 ebenfalls genügen; das höchstwertige bit vom Ausgang der Analog/Digital-Wandler 6, 7, 8 könnte bei diesen Verbindungen ausgelassen werden, denn beim selektierten Wert führt dieses bit immer nur »0«: auf diese detaillierte Darstellung wurde jedoch in Fig. 5 verzichtet, um in der Zeichnung und in den nachfolgenden Erläuterungen keine Unklarheiten zu verursachen.

Das im vorangehenden anhand der Schaltung beschriebene Verfahren besteht im wesentlichen darin, die drei Komponenten des Analogsignals zur Unterteilung einer Periode des Analogsignals in 12 Zonen heranzuziehen und jeweils den kleineren der drei Absolutwerte der Komponenten mit 4 bit zu digitalisieren, um in jeder Zone eine Interpolation in 16 Schritte zu erreichen, so daß schließlich eine Periode des Analogsignals in 192 Schritte unterteilt wird. Selbstverständlich kann eine Interpolation der Zonen in eine andere Anzahl Schritte durchgeführt werden. Im nachfolgenden wird auch gezeigt, daß zwei- und vierphasige Analogsignale gemäß demselben Verfahren interpoliert werden können. Schließlich ist es zweckmäßig, bei einem dreiphasigen Analogsignal die Komponenten auf der im vorangehenden beschriebenen Weise zu korrigieren, um sie von Nullpegelverschiebungen und Modulation zu befreien: dazu wird von jeder Komponente ein Drittel der Summe aller Komponenten subtrahiert.

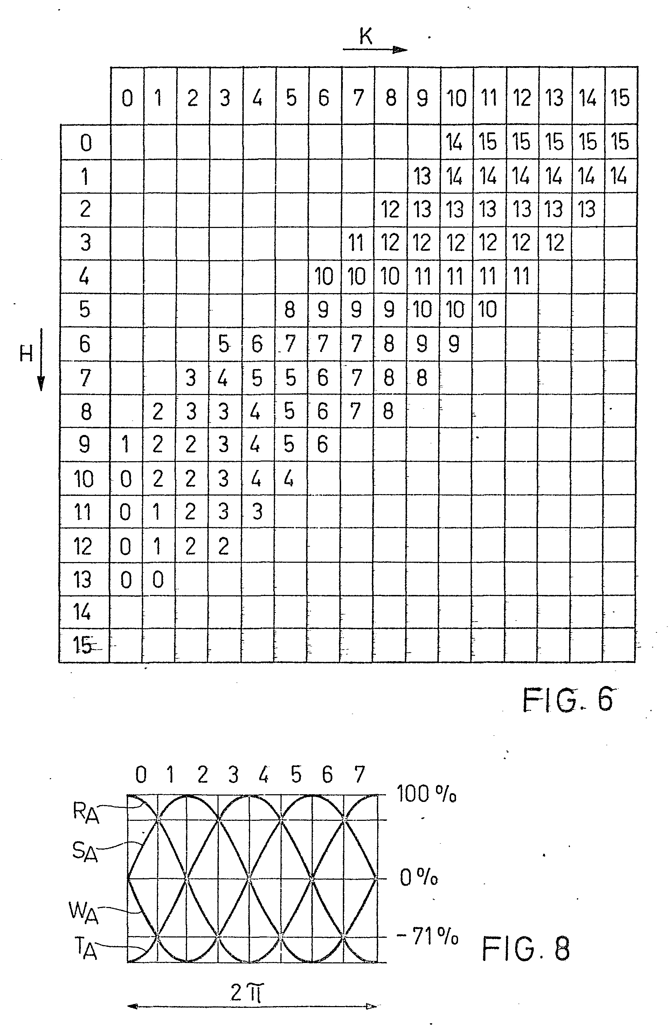

Die mit diesem Verfahren erreichte Interpolation ist jedoch empfindlich auf Änderungen der Amplituden der Komponenten des dreiphasigen Analogsignals sowie auf Wellenformen der Komponenten, die von einer Sinusoide abweichen. Zur Verminderung solcher Störeinflüsse kann die Information herangezogen werden, die in der beschriebenen Schaltung vorhanden ist, aber nicht genutzt wird, weil sie redundant ist. Aus den Werten X, Y, Z (vgl. Fig. 3) lassen sich Hilfswerte $H = Y - X$ und $K = Z - Y + X$ bilden, die in Fig. 5 mit dem gleichen Koordinatensystem wie in Fig. 3 dargestellt

6

werden. In Abhängigkeit des Phasenverlaufes in der Zone 0 ist der Verlauf der Hilfswerte H und K im Durchschnitt ziemlich linear. Wenn nun, z. B. einer Amplitudenänderung zufolge, die Werte R*, S*, T* um einen gleichen prozentualen Anteil steigen oder sinken (die Ursache kann z. B. in einer Schwankung der Speisespannung der Lichtquelle in einem Winkelmeßsystem gemäß dem Patentdokument CH-A-466 593 liegen), so steigt oder sinkt die durchschnittliche Neigung der beiden Linien H und K in Fig. 5 gleichzeitig um denselben Prozentsatz, weil die Hilfswerte H und K linear von X, Y, Z abhängig sind. Wenn die Wellenform von R*, S* und/oder T* von einer Sinuskurve abweicht, werden beide Linien H und K nach oben oder nach unten um etwa denselben Betrag versetzt oder gekrümmt, weil die Hilfswerte H und K auf dieselbe Weise vom Wert (Y−X) abhängig sind, während der Wert Z nur einen geringen Einfluß auf die Hilfswerte H und K ausübt. Somit läßt sich eine Tabelle gemäß Fig. 6 aufstellen, in der die in Kombination erscheinenden Hilfswerte H und K als Zeilen- bzw. als Spalteneingänge dienen, während im Element, wo sich je eine Zeile und eine Spalte kreuzen, ein der Kombination H, K entsprechender Phasenabschnitt oder Schritt bezeichnet wird. Man denke sich also, daß für jeden Phasenabschnitt oder Schritt, der auf der Abszisse der Fig. 5 liegt, die entsprechenden Ordinatenwerte auf den beiden Linien H und K abgelesen werden; dann werden diese Ordinatenwerte als Zeilen- bzw. Spalteneingänge verwendet, und im entsprechenden Element der Tabelle wird die Bezeichnung des entsprechenden Phasenabschnittes oder Schrittes eingetragen. Bei der Aufstellung dieser Tabelle hat sich herausgestellt, daß die 5-bit-Auflösung der Hilfswerte H und K viel zu hoch ist, da mehrere benachbarte Elemente in der Tabelle denselben Phasenabschnitt oder Schritt bezeichnen. Daher werden in der Tabelle der Fig. 6 die Hilfswerte H und K nur mit einer auf 4 bit reduzierten Auflösung eingeführt, was im Binärsystem sehr einfach durch Auslassen des niedrigstwertigen bit der in Fig. 5 abgelesenen Werte von H und K erreicht wird. Die Tabelle der Fig. 6 besteht also aus 256 statt 1024 Elementen, was bei der im nachfolgenden erläuterten Anwendung dieser Tabelle als Programmvorschrift für einen Zuordnungsspeicher (z. B. einen PROM) die Anzahl der benötigten Speicherplätze um einen Faktor vier reduziert.

Mit dem eben beschriebenen Vorgehen werden aber nur die etwa auf der einen Diagonale der Tabelle liegenden Elemente mit einer Bezeichnung versehen. Die Tabelle der Fig. 6 läßt sich nun erweitern oder weiter ausfüllen, indem die leerstehenden Elemente jeweils mit einer Bezeichnung versehen werden, die dem Phasenabschnitt oder Schritt entspricht, der beim Vorkommen der entsprechenden Hilfswertekombination am wahrscheinlichsten ist. Dazu stellt der Fachmann nach seinem Ermessen Arbeitshypothesen auf, welche verschiedene voraussehbare Fehlerarten des Analogsignals erfassen; daraus ergeben sich entsprechende Verschiebungen oder Deformationen der Linien H und K der Fig. 5, worauf das bereits geschilderte Vorgehen zum Ablesen einer Zuordnung eines Phasenabschnittes oder Schrittes und eines Paares von Hilfswerten H, K auf Fig. 5 und zum Eintragen dieser Zuordnung in die Tabelle der Fig. 6 weitergeführt wird. Die Tabelle der Fig. 6 liefert ein Beispiel des mit diesem Vorgehen erreichten Resultates.

Fig. 7 zeigt eine Ausbildung eines Teiles der Schaltung zur Verminderung der erwähnten Störeinflüsse durch Verwendung der Redundanz der Werte X, Y, Z. Wie in Fig. 4 werden die Werte |R|, |S|, |T| aus den in Fig. 7 nicht eingezeichneten Analog-Digital-Wandlern 6, 7, 8 den Vergleichern 41, 42, 43 zugeführt; ebenfalls wie in Fig. 4 erscheinen die Entscheidungen zu den Ungleichungen (d), (e), (f) an je einem Ausgang eines dieser Vergleicher, diese Entscheidungen werden in zwei logischen Gliedern 51 und 52 untereinander kombiniert, und der Ausgang je eines dieser logischen Glieder speist je einen Steuereingang des Selektionselementes 44, während je ein Werteingang des Selektionselementes 44 je einen der Werte |R|, |S|, |T| erhält. In Fig. sind zwei weitere Selektionselemente 71 und 72 dargestellt, welche ebenfalls je zwei Steuereingänge aufweisen und auf je einem Werteingang je einen der Werte |R|, |S|, |T| erhalten. Alle drei Selektionselemente 44, 71, 72 sind einander gleich und auf gleiche Weise geschaltet, indem beim Anstehen des Kodes 00 auf den Steuereingängen eines Selektionselementes derjenige Werteingang, der den Wert |R| führt, zum Ausgang des Selektionselementes durchgeschaltet wird, während beim Anstehen des Kodes 01 oder 10 dasselbe sinngemäß für den Wert |S| und beim Anstehen des Kodes 11 dasselbe sinngemäß für den Wert |T| gilt. Wie in Fig. 4 sind die logischen Glieder 51 und 52 ein UND-Glied 51 und ein ODER-Glied 52, deren Schaltung die Funktionen (e * f̄) bzw. (d = f̄) ausführt. In Fig. 7 vier weitere logische Glieder 53, 54, 55, 56 dargestellt. Die logischen Glieder 53 und 54 sind ein Antivalenz-Glied 53 und ein Äquivalenz-Glied 54, deren Ausgänge je einen Steuereingang des Selektionselementes 71 speisen. Je ein Eingang des Antivalenz-Gliedes 53 ist mit je einem Ausgang der Vergleicher 41 und 43 verbunden, um die Funktion (d * f̄ + d̄ * f) auszuführen; je ein Eingang des Äquivalenz-Gliedes 54 ist mit je einem Ausgang der Vergleicher 42 und 43 verbunden, um die Funktionen (e * f + ē * f̄) auszuführen; das Selektionselement 71 erhält also auf je einem Steuereingang je eine dieser Funktionen. Die logischen Glieder 55 und 56 sind ein ODER-Glied 55 und ein UND-Glied 56, deren Ausgänge je einen Steuereingang des Selektionselementes 72 speisen. Je ein Eingang des ODER-Gliedes 55 ist mit je einem Ausgang der Vergleicher 41 und 43 verbunden, um die Funktion (d̄ + f) auszuführen, wobei der mit dem Vergleicher 41 verbundene Eingang invertierend ist; je ein Eingang des UND-Gliedes 56 ist mit je einem Ausgang der Vergleicher 42 und 43 verbunden, um die Funktion (ē * f) auszuführen, wobei der mit dem Vergleicher 41 verbundene Eingang invertierend ist. Es läßt sich anhand der Tabellen II und III zeigen, daß auf diese Weise das Selektionselement 44 immer den kleineren, das Selektionselement 72

immer den größeren und das Selektionselement 71 immer den mittleren der drei Werte $|R|$, $|S|$, $|T|$ zu ihrem Ausgang durchschalten. Der kleinere Wert wird mit X, der mittlere mit Y und der größere mit Z bezeichnet, wie aus Fig. 3 ersichtlich ist. Die Schaltung zum Bilden der richtigen Kodes auf den Steuereingängen der Selektionselemente könnte übrigens anders als mit der im vorstehenden beschriebenen Schaltung ausgeführt werden, z. B. mit einem Zuordnungsspeicher, der auf drei Eingängen die Entscheidungen (d), (e), (f) als Adresse erhält und auf drei Paaren von Ausgängen die entsprechenden Kodes liefert. Es ist auch noch zu bemerken, daß die Werte X, Y, Z durch Auslassen des niedrigstwertigen bit am Ausgang des jeweiligen Selektionselementes 44, 71, 72 und 4-bit-Werte anstehen, weil hier eine 4-bit-Auflösung genügt, wie im Zusammenhang mit der Tabelle in Fig. 6 erläutert wurde.

Die Schaltung zum Bilden der im Zusammenhang mit Fig. 5 definierten Hilfswerte H, K aus den Werten X, Y, Z besteht im wesentlichen aus den binären Subtrahierwerken 73, 74 der Fig. 7, die auf an sich bekannte Weise zur Ausführung der Funktionen $H = Y - X$ und $K = Z - Y + X$ geschaltet sind. Vom 4-bit Ausgang je eines der Subtrahierwerke 73, 74 wird je ein Hilfswert H, K je einem 4-bit-Adressiereingang eines Zuordnungsspeichers 75, beispielsweise eines PROM, zugeführt; an einem 4-bit-Ausgang dieses Zuordnungsspeichers 75 erscheint der durch die Hilfswerte H und K adressierte Wert gemäß den Angaben, die in der Tabelle der Fig. 6 dezimal eingetragen sind. Der 4-bit-Ausgang des Zuordnungsspeichers 75 wird ähnlich wie der Ausgang des Selektors 11 der Fig. 1 je einem Eingang eines Antivalenz-Gliedes 12 zugeführt, während je einem anderen Eingang der Antivalenz-Glieder 12 wie in Fig. 1 das niedrigstwertige bit LSB aus dem Zuordnungsspeicher 10 zugeführt wird. Die Funktion der Antivalenz-Glieder 12 und des Zuordnungsspeichers 10 ist dieselbe wie in Fig. 1, erscheint, wie in Fig. 1, nach der Vereinigung der Ausgangsleistungen bei 13 zu einer 8-bit-Leitung 14, das Ergebnis der Interpolation des dreiphasigen Analogsignals R\*, S\*, T\* in 192 Schritten pro Periode, jedoch hier weitgehend von den Fehlern befreit, die durch Änderungen der Amplituden der Komponenten des Analogsignals oder durch von einer Sinusoide abweichende Wellenformen dieser Komponenten verursacht werden.

Die im vorangehenden anhand der Schaltung beschriebene Verbesserung des Verfahrens besteht also im wesentlichen darin, jeweils die kleinere (X), die mittlere (Y) und die größere (Z) Komponente des dreiphasigen Analogsignals mit 4 bit zu digitalisieren und sie gemäß $H = Y - X$ und $K = Z - Y + X$ zu kombinieren, um zwei mit der Phase des Analogsignals im Durchschnitt etwa linear verlaufende Hilfswerte H, K zu bilden. Mit diesen Hilfswerten wird ein Zuordnungsspeicher adressiert, dessen Ausgang die Bezeichnung eines entsprechenden Interpolationsschrittes liefert. Dabei wird die bei der gleichzeitigen Verwendung der Werte X, Y, Z auftretende Redundanz ausgenutzt, um den Einfluß von Amplitudenänderungen und Wellenformfehlern des dreiphasigen Analogsignals zu vermeiden.

Im Falle eines zweiphasigen Analogsignals mit um $\frac{n}{2}$ phasenverschobenen Komponenten R\*, S\* lassen sich die Komponenten nicht durch Subtrahieren von

$$\frac{R^* + S^*}{2}$$

korrigieren; der entsprechende Schaltungsteil muß ausgelassen werden, es müssen $R_A = R^*$ und $S_A = S^*$ gesetzt werden. Anhand der Fig. 8, die für ein zweiphasiges Analogsignal der Fig. 2 entspricht, ist zu erkennen, daß die Periode des zweiphasigen Analogsignals $R_A$, $S_A$ durch die Ereignisse $R_A = 0$, $S_A = 0$ und $|R_A| = |S_A|$ in 8 Zonen unterteilbar ist. Im Falle eines vierphasigen Analogsignals mit jeweils um $\frac{n}{2}$ phasenverschobenen Komponenten kann hingegen ein korrigiertes Analogsignal $R_A$, $S_A$, $T_A$, $W_A$ erzeugt werden, indem von den Komponenten R\*, S\*, T\*, W\* jeweils die Summe

$$\frac{R^* + S^* + T^* + W^*}{4}$$

subtrahiert wird. Anhand der Fig. 8, die auch für ein vierphasiges Analogsignal der Fig. 2 entspricht, ist zu erkennen, daß auch die Periode des vierphasigen Analogsignals $R_A$, $S_A$, $T_A$, $W_A$ durch die Ereignisse $R_A = 0$, $|R_A| = |S_A|$ usw. in 8 Zonen unterteilbar ist. In diesen beiden Fällen lassen sich jedoch nur zwei Werte X und Y bilden, die als der kleinere (X) und der größere (Y) der Absolutwerte der digitalisierten Komponenten definiert werden; beim vierphasigen Analogsignal sind die Absolutwerte der korrigierten Komponenten nämlich zu zweien gleich. Da nun in diesen Fällen die Variationsspanne des Wertes X zwischen 0% und 71% der Amplitude 100% liegt, ist es vorteilhaft, eine solche Verstärkung vorzusehen, daß gerade diese Variationsspanne in 16 Schritte genau aufgelöst wird: dann wird der

8

einer Zone entsprechende Phasenabschnitt von hier $\frac{\pi}{4}$ wiederum in 16 Schritte unterteilt. Diese Unterteilung ist zwar bei weitem nicht linear (1 Schritt ist 50,3 bis 66,3 mrad wert), die Linearität ließe sich jedoch auch durch Bildung eines Hilfswertes $H = Y - X$ nicht wesentlich verbessern. Zwei- und vierphasige Analogsignale sind also in 8 Zonen zu 16 Schritten, d. h. in 128 Schritte interpolierbar. Bei einem Meßsystem wird jedoch die Erzeugung und die Übertragung des Meßwertes durch ein dreiphasiges Analogsignal bevorzugt, weil damit bei kleinerer Verstärkung mehr Schritte und eine bessere Linearität der Interpolation erreichbar sind. Für die Fälle eines zweiphasigen Analogsignals und eines vierphasigen Analogsignals wird hier kein Patentschutz beansprucht.

Bei der erwähnten typischen Anwendung des beschriebenen Verfahrens und der beschriebenen Schaltung zur Winkelmessung in einem Flugbahnvermessungs-Theodoliten beträgt die mit der Erfindung erreichte Auflösung 50 000 Perioden zu 192 Schritten für eine volle Umdrehung, d. h. 9,6 Millionen Schritte pro Umdrehung. Bei der kleinsten verwendeten Drehgeschwindigkeit (eine Umdrehung pro Tag) wird eine zeitliche Informationsdichte von etwa 111 Schritten pro Sekunde erreicht, was um fast einen Faktor 5 besser ist als die beim bisherigen Stand der Technik erreichte zeitliche Informationsdichte. Bei der maximalen Drehgeschwindigkeit (etwa 1,6 rad/s) beträgt die zeitliche Informationsdichte etwa 40 Millionen Schritte pro Sekunde, d. h., ein Schritt muß innerhalb etwa 25 ns erfaßt werden: ist eine solche zeitliche Informationsdichte für das Verarbeitungsvermögen der Elektronik des Servo-Antriebes zu hoch, so ist es im Binärsystem sehr leicht, die Anzahl Schritte pro Zeiteinheit als Gleitkomma-Binärzahl mit einer konstanten Stellenzahl auszudrücken und dabei eine gewisse Anzahl niedrigwertigeren Stellen, auf denen die zeitliche Informationsdichte zu hoch ist, zu unterdrücken.

## Patentansprüche

1. Verfahren zur Digitalisierung einer dreiphasigen Analogsignals, dessen Komponenten (Phasen) eine periodische Funktion einer Meßgröße — insbesondere der Position bei einer Längen- oder Winkelmessung — sind, wobei die Werte der Komponenten mit Null sowie zu zweien untereinander verglichen werden, jeder möglichen Kombination der Vergleichsergebnisse je eine im Bereich der Phasenargumente des Analogsignals definierte Zone zugeordnet wird, und der Wert mindestens einer der Komponenten analog/digital gewandelt wird, dadurch gekennzeichnet, daß von den analog/digital gewandelten Werten aller drei Komponenten jeweils derjenige mit dem kleinsten, genannt X, dem mittleren genannt Y und dem größten, genannt Z Absolutwert bestimmt werden, zwei digitale Hilfswerte (H, K) entsprechend den Funktionen $H = Y - X$ und $K = Z - Y + X$ gebildet werden und jeder möglichen Kombination dieser Hilfswerte eine bestimmte Anzahl Schritte des Phasenarguments innerhalb der Zone zugeordnet wird.

2. Verfahren nach Anspruch 1, dadurch gekennzeichnet, daß die Summe der Komponenten des dreiphasigen Analogsignals (R*, S*, T*) gebildet und ein Drittel dieser Summe von jeder dieser Komponenten subtrahiert wird, um je eine korrigierte Komponente ($R_A$, $S_A$, $T_A$) zu erzeugen, deren Wert analog/digital gewandelt wird, um den entsprechenden digitalen Absolutwert (X, Y, Z) zu erzeugen.

## Claims

1. A method for digitizing a three-phase analog signal whose components (phases) are a periodic function of a measured quantity — especially of the position in the case of a length or angle measurement —, wherein the values of the components are compared with zero and in twos with each other, each possible combination of the comparison results is allocated a respective zone defined within the range of phase arguments of the analog signal, andere there is performed on the value of at least one component an analog-to-digital conversion, characterized in that there is determined among the analog-to-digital-converted values of all three components the respective one whose absolute value is smallest, labelled X, intermediate, labelled Y, and largest, labelled Z, there are formed two digital auxiliary values (H, K) corresponding to the functions $H = Y - X$ and $K = Z - Y + X$, and there is allocated to each possible combination of such auxiliary values a predetermined number of steps of the phase argument within the zone.

2. A method according to claim 1 characterized in that there is formed the sum of the components of the three-phase analog signal (R*, S*, T*) and there is substracted one-third of such sum from each of said components for obtaining a respective corrected component ($R_A$, $S_A$, $T_A$) on the value of which there is performed an analog-to-digital conversion in view of obtaining the corresponding digital absolute value (X, Y, Z).

# 0 006 492

## Revendications

1. Procédé de digitalisation d'un signal analogique triphasé dont les composantes (phases) sont une fonction periodique d'une grandeur à mesurer — en particulier de la position dans le cas d'une mesure de longueur ou d'angle — et dans lequel on compare les valeurs des composantes avec zéro ainsi qu'entre elles deux par deux, on attribue à chaque combinaison possible de résultats des comparaisons une zone respective définie dans le domaine des arguments de phase du signal analogique et l'on effectue une conversion analogique/digitale de la valeur de l'une au moins des composantes, procédé caractérisé en ce que l'on détermine parmi les valeurs de toutes les trois composantes après leur conversion analogique/digitale celle dont la valeur absolue est respectivement la plus petite, nommée X, intermédiaire, nommée Y, et la plus grande, nommée Z, l'on forme deux valeurs auxiliaires digitales (H, K) correspondant aux fonctions $H = Y - X$ et $K = Z - Y + X$ et l'on attribue à chaque combinaison possible de ces valeurs auxiliaires un nombre prédéterminé de pas de l'argument de phase à l'intérieur de la zone.

2. Procédé selon la revendication 1 caractérisé en ce que l'on forme la somme des composantes du signal analogique triphasé (R*, S*, T*) et que l'on retranche de chacune de ces composantes un tiers de cette somme pour former chaque fois une composante corrigée ($R_A$, $S_A$, $T_A$) dont on soumet la valeur à une conversion analogique/digitale en vue de former la valeur absolue digitale correspondante (X, Y, Z).

10

FIG. 1

$\downarrow R^*$   $\downarrow S^*$   $\downarrow T^*$

1

$\dfrac{R^*+S^*+T^*}{3}$

2   $\triangleright \dfrac{1}{3}$

$(-)$   3   $(-)$   4   $(-)$   5

$\downarrow R_A$   $\downarrow S_A$   $\downarrow T_A$

6   $\dfrac{A}{D}$   7   $\dfrac{A}{D}$   8   $\dfrac{A}{D}$

$(+),(-) \downarrow$

$\downarrow \begin{matrix} |R| \\ |S| \\ |T| \end{matrix}$

10

PROM

| | |
|---|---|
| $(R>0)$ | $(|R|>|S|)$ |
| $(S>0)$ | $(|S|>|T|)$ |
| $(T>0)$ | $(|T|>|R|)$ |

9

11   $X = \min(|R|,|S|,|T|)$

LSB

$=1$   $=1$   $=1$   $=1$

12   12   12   12

13   14

FIG. 2

FIG. 3

FIG. 4

FIG. 5

K →

| | 0 | 1 | 2 | 3 | 4 | 5 | 6 | 7 | 8 | 9 | 10 | 11 | 12 | 13 | 14 | 15 |
|---|---|---|---|---|---|---|---|---|---|---|---|---|---|---|---|---|
| 0 | | | | | | | | | | | 14 | 15 | 15 | 15 | 15 | 15 |
| 1 | | | | | | | | | | 13 | 14 | 14 | 14 | 14 | 14 | 14 |
| 2 | | | | | | | | | 12 | 13 | 13 | 13 | 13 | 13 | 13 | |
| 3 | | | | | | | | 11 | 12 | 12 | 12 | 12 | 12 | 12 | | |
| 4 | | | | | | | 10 | 10 | 10 | 11 | 11 | 11 | 11 | | | |
| 5 | | | | | | 8 | 9 | 9 | 9 | 10 | 10 | 10 | | | | |
| 6 | | | 5 | 6 | 7 | 7 | 7 | 8 | 9 | 9 | | | | | | |
| 7 | | 3 | 4 | 5 | 5 | 6 | 7 | 8 | 8 | | | | | | | |
| 8 | | 2 | 3 | 3 | 4 | 5 | 6 | 7 | 8 | | | | | | | |
| 9 | 1 | 2 | 2 | 3 | 4 | 5 | 6 | | | | | | | | | |
| 10 | 0 | 2 | 2 | 3 | 4 | 4 | | | | | | | | | | |
| 11 | 0 | 1 | 2 | 3 | 3 | | | | | | | | | | | |
| 12 | 0 | 1 | 2 | 2 | | | | | | | | | | | | |
| 13 | 0 | 0 | | | | | | | | | | | | | | |
| 14 | | | | | | | | | | | | | | | | |
| 15 | | | | | | | | | | | | | | | | |

H ↓

FIG. 6

FIG. 8